(19) Europäisches Patentamt

European Patent Office

Office européen des brevets

(11) **EP 1 531 503 A1**

(12) **EUROPEAN PATENT APPLICATION**

(43) Date of publication:
**18.05.2005 Bulletin 2005/20**

(51) Int Cl.⁷: **H01L 51/20**, H01L 27/00

(21) Application number: **04027000.1**

(22) Date of filing: **12.11.2004**

| | |
|---|---|
| (84) Designated Contracting States: **AT BE BG CH CY CZ DE DK EE ES FI FR GB GR HU IE IS IT LI LU MC NL PL PT RO SE SI SK TR** Designated Extension States: **AL HR LT LV MK YU** (30) Priority: **12.11.2003 KR 2003079782** (71) Applicant: **LG ELECTRONICS INC.** **Seoul (KR)** | (72) Inventors: • **Sunwoo, Jin Ho** **Gumi-si Gyeongsangbuk-do (KR)** • **Kang, Min Su** **Suseong-gu Daegu (KR)** • **Tak, Yoon Heung** **Gumi-si Gyeongsangbuk-do (KR)** (74) Representative: **Heinze, Ekkehard, Dr. et al Meissner, Bolte & Partner Gbr, Postfach 10 26 05 86016 Augsburg (DE)** |

(54) **Organic electro-luminescence device and fabricating method thereof**

(57)    An organic electro-luminescence device and a fabricating method thereof for simplifying a structure and a manufacturing process of the device are disclosed. In the organic electro-luminescence device, an anode electrode is provided between a substrate and an organic light-emitting layer and has a large amount of holes distributed on the surface being adjacent to the organic light-emitting layer such that said holes are directly injected into the organic light-emitting layer. A cathode electrode is provided on the organic light-emitting layer.

FIG.3

EP 1 531 503 A1

## Description

This application claims the benefit of Korean Patent Application No. P2003-79782 filed in Korea on November 12, 2003, which is hereby incorporated by reference.

## BACKGROUND OF THE INVENTION

Field of the Invention

This invention relates to an electro-luminescence display (ELD), and more particularly to an organic electro-luminescence device and a fabricating method thereof that are adaptive for simplifying a structure and a manufacturing process of the device.

Description of the Related Art

Recently, there have been developed various flat panel display devices reduced in weight and bulk that is capable of eliminating disadvantages of a cathode ray tube (CRT). Such flat panel display devices include a liquid crystal display (LCD), a field emission display (FED), a plasma display panel (PDP) and an electro-luminescence (EL) display, etc. Also, there have been actively processed studies for attempting to make a high display quality and a large-dimension screen of the flat panel display device.

In such flat panel display devices, the PDP has drawbacks in that it has been highlighted as the most advantageous display device to make a light weight, a small size and a large dimension screen because its structure and manufacturing process are simple, but it has low light-emission efficiency and large power consumption. On the other hand, the active matrix LCD employing a thin film transistor (TFT) as a switching device has drawbacks in that it is difficult to make a large dimension screen because a semiconductor process is used, and in that it has large power consumption due to a backlight unit and has a large light loss and a narrow viewing angle due to optical devices such as a polarizing filter, a prism sheet, a diffuser and the like. However, the LCD is mainly used for a notebook personal computer and has an expanded demand.

Meanwhile, the EL device is largely classified into an inorganic electro-luminescence device and an organic electro-luminescence device depending upon a material of a light-emitting layer, and is a self-luminous device. When compared with the above-mentioned display devices, the EL device has advantages of a fast response speed, large light-emission efficiency, a large brightness and a large viewing angle. The inorganic electro-luminescence device has a larger power consumption than the organic electro-luminescence device and can not obtain a higher brightness than the organic electro-luminescence device. On the other hand, the organic electro-luminescence device is driven with a low direct current voltage of tens of volts, and has a fast response speed. Also, the organic electro-luminescence device can obtain a high brightness, and can emit various colors of red(R), green(G) and blue(B). Thus, the organic electro-luminescence device is suitable for a post-generation flat panel display device.

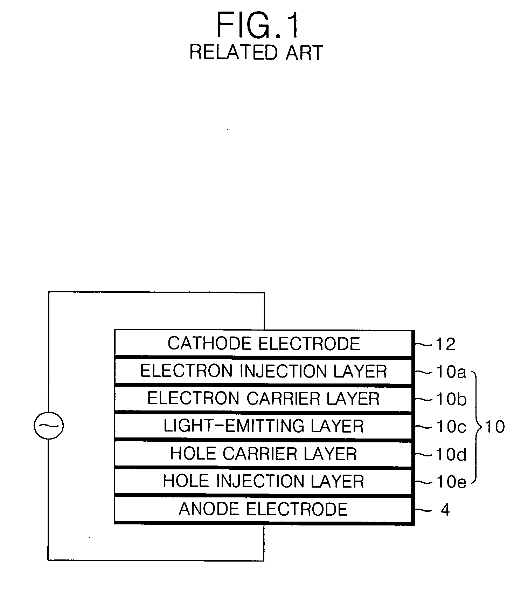

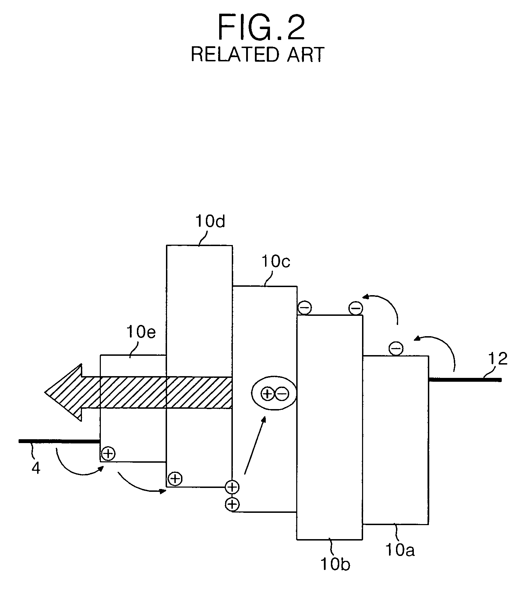

Fig. 1 and Fig. 2 are section views showing a portion of a general EL device for explaining a light-emitting principle of the EL display device.

Referring to Fig. 1 and Fig. 2, the EL device includes an organic light-emitting layer 10 provided between an anode electrode 4 and a cathode electrode 12, which is comprised of an electron injection layer 10a, an electrode carrier layer 10b, a light-emitting layer 10c, a hole carrier layer 10d and a hole injection layer 10e.

If a voltage is applied between the anode electrode 4 and the cathode electrode 12 of the EL device, electrons produced from the cathode electrode 12 are moved, via the electron injection layer 10a and the electron carrier layer 10b, into the light-emitting layer 10c. Further, holes produced from the anode electrode 4 are moved, via the hole injection layer 10e and the hole carrier layer 10d, into the light-emitting layer 10c. Thus, electrons and holes fed from the electron carrier layer 10b and the hole carrier layer 10d, respectively, are collided with each other at the light-emitting layer to be recombined to generate a light. This light is emitted, via the anode 4, into the exterior to thereby display a picture.

Meanwhile, the hole injection layer 10e controls a concentration of the holes while the hole carrier layer 10d controls a movement speed of the holes, thereby allowing the holes produced from the anode electrode 4 to be easily injected into the light-emitting layer 10c. In other words, the holes produced from the anode electrode 4 fail to be easily moved into the light-emitting layer 10c by an interface energy of the light-emitting layer 10c, but can be easily injected into the light-emitting layer 10c by the hole injection layer 10e between the anode electrode 4 and the light-emitting layer 10c.

However, such a conventional EL device has a problem in that, since it requires an additional process for forming the hole injection layer 10e and the hole carrier layer 10d, a structure and a manufacturing process of the device becomes complicate.

## SUMMARY OF THE INVENTION

Accordingly, it is an object of the present invention to provide an organic electro-luminescence device and a fabricating method thereof that are adaptive for simplifying a structure and a manufacturing process of the device.

In order to achieve these and other objects of the invention, an organic electro-luminescence device according to one aspect of the present invention includes an anode electrode provided between a substrate and an organic light-emitting layer and having a large amount of holes distributed on the surface being adjacent to the organic light-emitting layer such that said holes are directly injected into the organic light-emitting layer; and a cathode electrode provided on the organic light-emitting layer.

In the organic electro-luminescence device, the anode electrode has a small amount of holes distributed at an area adjacent to the substrate while having a large amount of holes distributed at an area adjacent to the organic light-emitting layer.

In the organic electro-luminescence device, the organic light-emitting layer includes a light-emitting layer formed on the anode electrode; an electron carrier layer formed on the light-emitting layer; and an electron injection layer formed on the electron carrier layer.

A method of fabricating an organic electro-luminescence device according to another aspect of the present invention includes the steps of forming an anode electrode on a substrate; forming an organic light-emitting layer on the anode electrode; and forming a cathode electrode on the organic light-emitting layer, wherein said anode electrode has a large amount of holes distributed on the surface being adjacent to the organic light-emitting layer such that said holes are directly injected into the organic light-emitting layer.

In the method, said step of forming the anode electrode on the substrate includes colliding plasma ions with a transparent electrode material target within a chamber; injecting a large amount of oxygen at a second half time of a deposition of said transparent electrode material by said ion collision; and reacting said transparent electrode material with said oxygen, thereby producing a large amount of holes.

In the method, the anode electrode has a small amount of holes distributed at an area adjacent to the substrate while having a large amount of holes distributed at an area adjacent to the organic light-emitting layer.

Said step of forming the organic light-emitting layer includes forming a light-emitting layer connected to the anode electrode; forming an electron carrier layer on the light-emitting layer; and forming an electron injection layer on the electron carrier layer.

**BRIEF DESCRIPTION OF THE DRAWINGS**

These and other objects of the invention will be apparent from the following detailed description of the embodiments of the present invention with reference to the accompanying drawings, in which:

Fig. 1 is a schematic block diagram showing a structure of an organic light-emitting layer in a conventional organic electro-luminescence device;

Fig. 2 is a view for explaining a light-emitting principle of the conventional organic electro-luminescence device;

Fig. 3 is a plan view showing a structure of an organic electro-luminescence device according to an embodiment of the present invention;

Fig. 4 is a section view of a portion of the organic electro-luminescence device shown in Fig. 3;

Fig. 5 is a detailed block diagram of the organic light-emitting layer of the organic electro-luminescence device according to the embodiment of the present invention;

Fig. 6 depicts a distribution of holes within the anode electrode of the organic electro-luminescence device according to the embodiment of the present invention; and

Fig. 7A to Fig. 7E show a method of fabricating the organic electro-luminescence device according to the embodiment of the present invention.

**DETAILED DESCRIPTION OF THE PREFERRED EMBODIMENT**

Reference will now be made in detail to the preferred embodiments of the present invention, examples of which are illustrated in the accompanying drawings.

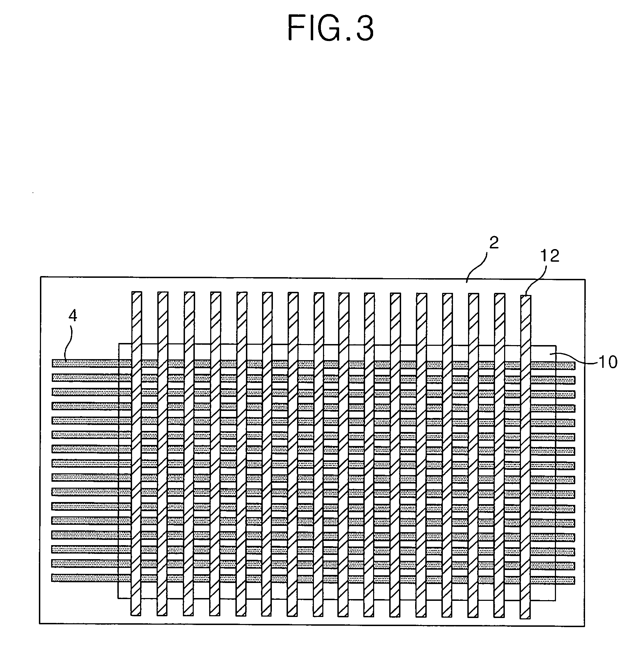

Hereinafter, the preferred embodiments of the present invention will be described in detail with reference to Figs. 3 to 7E.

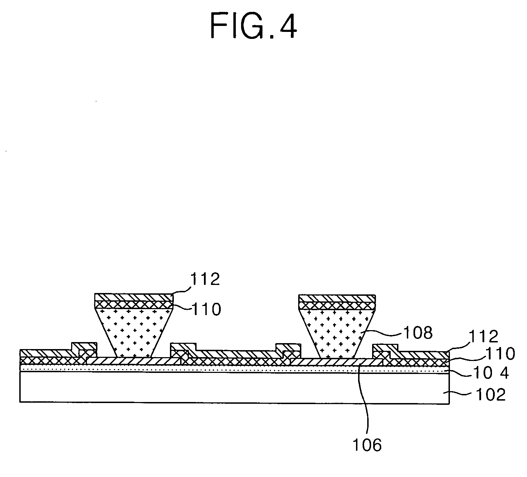

Fig. 3 is a plan view showing a structure of an organic electro-luminescence (EL) device according to an embodiment of the present invention, and Fig. 4 is a section view of a portion of the EL device shown in Fig. 3.

Referring to Fig. 3 and Fig. 4, the EL device has an anode electrode 104 and a cathode electrode 112 provided on a substrate 102 in a direction crossing each other.

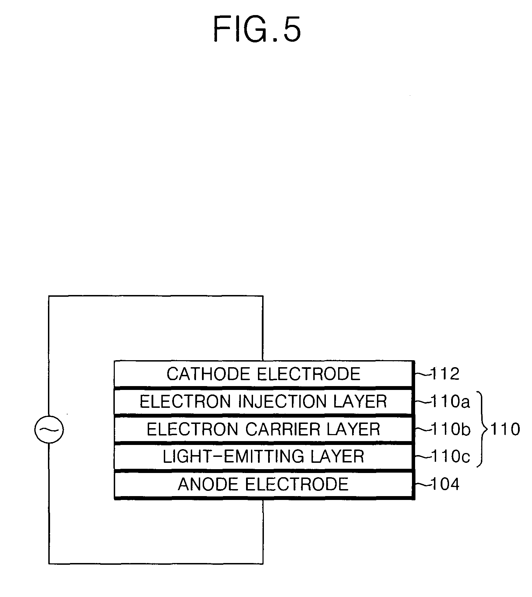

A plurality of anode electrodes 104 are provided on the substrate 102 in such a manner to be spaced at a desired distance from each other. An insulating film 106 having an aperture for each EL cell area is formed on the substrate 102 provided with the anode electrode 104. A barrier rib 108 for separating an organic light-emitting layer 110 and the cathode electrode 112 to be formed thereon is positioned on the insulating film 106. The barrier rib 108 is provided in a direction crossing the anode electrode 104 and has an overhang structure in which the upper portion thereof has a larger width than the lower portion thereof. The organic light-emitting layer 110 and the cathode electrode 112 formed from an organic compound are sequentially and entirely deposited onto the substrate 102 provided with the barrier rib 108. The organic light-emitting layer 110 eliminates a hole injection layer and a hole carrier layer in comparison with the prior art, and is comprised of a light-emitting layer 110c, an electron carrier layer 110b and an electron injection layer 110a as shown in Fig. 5.

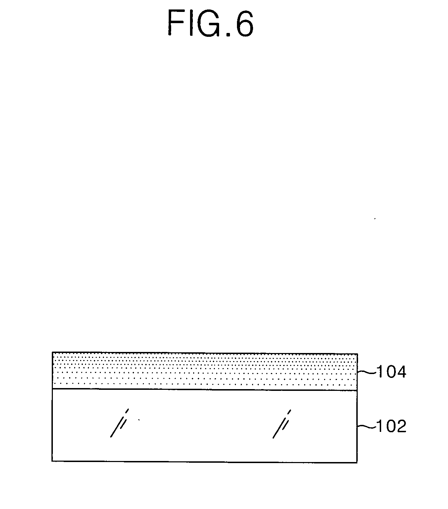

As shown in Fig. 6, the anode electrode 104 is formed such that, as it goes from the upper layer thereof into the lower layer thereof, an amount of holes are more gradually increased. Thus, the upper layer surface of the anode electrode 104 is intimate with a large amount of holes. Accordingly, even though the hole injection layer and the hole carrier layer in the prior art do not exist, holes produced from the anode electrode 104 can be easily injected into the light-emitting layer 110c.

In the EL device having the above-mentioned structure, if a voltage is applied between the anode electrode 104 and the cathode electrode 112, electrons produced from the cathode electrode 112 are moved, via the electron injection layer 110a and the electron carrier layer 110b, into the light-emitting layer 110c. Further, a large amount of holes produced from the anode electrode 104 are directly moved into the light-emitting layer 110c. Thus, electrons produced from the cathode electrode 112 collides with holes produced from the anode electrode 104 at the light-emitting layer 110c to be recombined with each other, thereby generating a light. This light is emitted, via the anode 104, into the exterior to thereby display a picture.

As described above, in the EL device according to the embodiment of the present invention, a large amount of holes are intimate with each other at the upper layer of the anode electrode 104, so that a large amount of holes in the anode electrode 102 can overcome an interface energy of the light-emitting layer 110c to be injected into the light-emitting layer 110c even though the hole injection layer and the hole carrier layer in the prior art do not exist in the organic light-emitting layer 110. Thus, the organic light-emitting layer 110 consists of the light-emitting layer 110c, the electron carrier layer 110b and the electron injection layer 110a, thereby simplifying a structure and a manufacturing process of the EL device.

Hereinafter, a method of fabricating the organic EL device according to the embodiment of the present invention will be described.

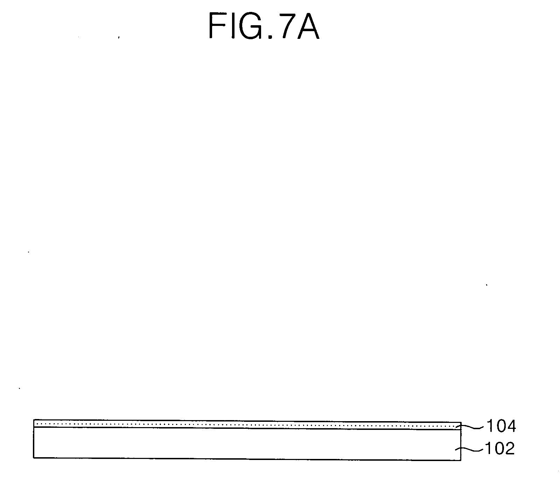

Firstly, a transparent conductive metal material is deposited onto the substrate 102 formed from a soda lime or a hardened glass by a deposition technique such as a sputtering using argon (Ar) plasma, etc., and then is patterned by the photolithography and the etching process. Thus, the anode electrode 104 is formed as shown in Fig. 7A. Herein, indium-tin-oxide (ITO) is used as the metal material.

A method of forming the anode electrode 104 will be described in detail below. Subsequently, argon ions (Ar+) produced by applying a voltage collide with a ITO target ($In_xSn_2$-$XO_y$) to thereby deposit ITO molecule ions onto the substrate 102. Herein, an injected amount of oxygen is gradually increased as a deposition amount of the ITO molecule ions deposited on the substrate 102. Thus, as it goes into the upper layer thereof, an amount of holes is increased, to thereby form the anode electrode 104 having a shape in which a large amount of holes are intimate with each other at the surface thereof. In other words, a small amount of oxygen is injected at an initial time of the deposition and then the injected oxygen amount is gradually increased. At a finishing time of the deposition, a large amount of oxygen is injected to thereby provide the anode electrode 104 containing

oxygen ions ($O_2$-) and a large amount of holes.

Such a principle of hole production will be described in conjunction with a concept of chemical reaction as follows. According to a general hole production principle, the a replacement reaction of $Sn_2O_3$ of the anode electrode ($In_xSn_2$-$XO_y$) with $3In_2+$ is made to produce $3In_2O_2$ and $2Sn_3+$ as indicated by the following chemical reaction equation (1), and then holes are produced by a positive ion $2Sn_3+$ that loses electrons by the charge amount conservation law.

$$A.\ Sn_2O_3 + 3In_2+ \rightarrow 3In_2O_2 + 2Sn_3+ \qquad (1)$$

Holes produced by the foregoing general production principle and a large amount of oxygen ($O_2$) is injected at a finishing time of the deposition of the anode electrode 102. Then, the injected oxygen ($O_2$) reacts with electrons of the ITO ($In_xSn_2$-$XO_y$) to produce an oxygen ion ($O_2$-), and the ITO ($In_xSn_2$-$XO_y$) more produces holes corresponding to an amount of the lost oxygen. Thus, an amount of holes at the anode electrode 104 is more increased as it goes from the lower layer thereof into the upper layer thereof, so that a very large amount of holes are intimate with each other at the upper layer surface thereof. As a result, the holes produced from the anode electrode 104 overcomes an interface energy of the light-emitting layer 110c to be inputted to the light-emitting layer 110c even though the hole injection layer and the hole carrier layer do not exist.

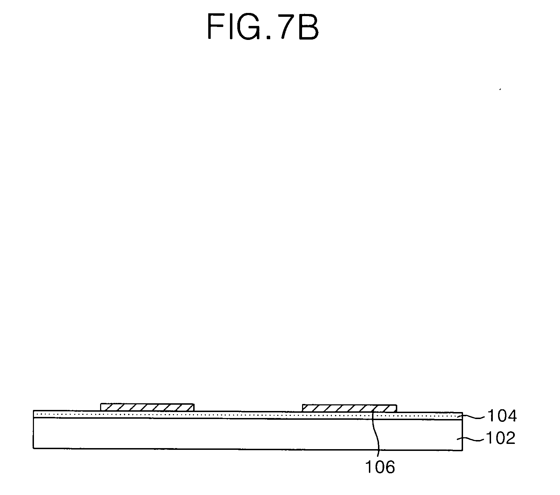

Subsequently, a photo-sensitive insulating material is coated onto the substrate 102 provided with the anode electrode 104, and then is patterned by the photolithography. Thus, the insulating film 106 is provided such that a light-emitting area is exposed as shown in Fig. 7B.

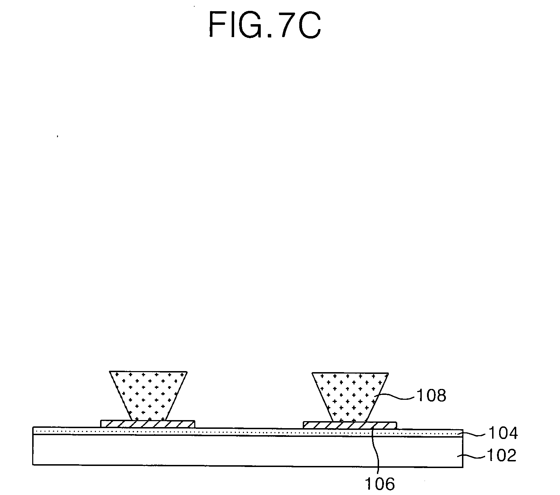

A photo-sensitive organic material is deposited onto the insulating film 106 and then is patterned by the photolithography, to thereby provide the barrier rib 108 as shown in Fig. 7C. The barrier rib 108 is formed at a non-emitting area in such a manner to cross a plurality of anode electrodes 104 so as to divide the pixels.

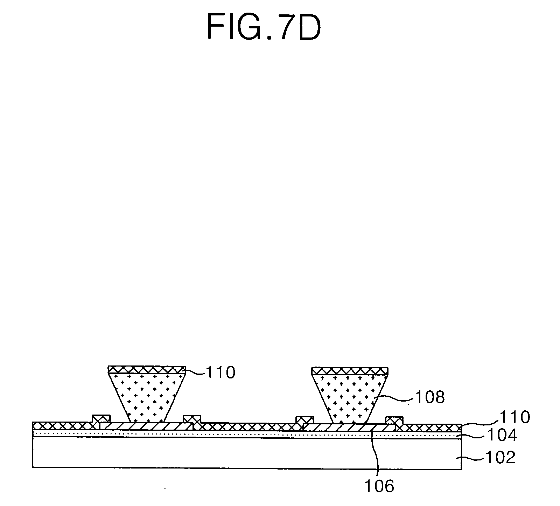

An organic luminous material is deposited onto the substrate 102 provided with the barrier rib 108 as shown in Fig. 7D by the vacuum deposition technique to thereby provide the organic light-emitting layer 110. The organic light-emitting layer 110 is provided at an area divided by the barrier rib 108.

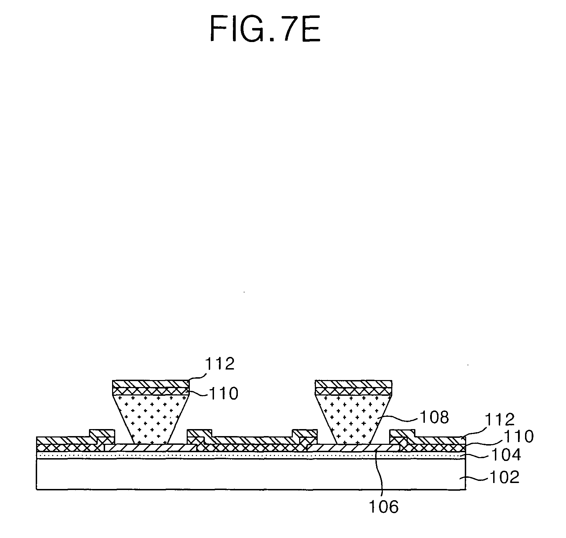

Finally, a metal material is deposited onto the substrate 102 provided with the organic light-emitting layer 110 to thereby provide the cathode electrode 112 as shown in Fig. 7E. Herein, aluminum (Al) or LiF, etc. is used as the metal material.

As described above, according to the present invention, the anode electrode having a shape in which a larger amount of holes are intimate with each other as it goes from the upper layer thereof into the lower layer thereof, thereby injecting holes from the anode electrode into the organic light-emitting layer even though the hole injection layer and the hole carrier layer in the prior art do not exist. Accordingly, a necessity of the hole injection layer and the hole carrier layer can be eliminated to simplify a structure and a manufacturing process of the device.

Although the present invention has been explained by the embodiments shown in the drawings described above, it should be understood to the ordinary skilled person in the art that the invention is not limited to the embodiments, but rather that various changes or modifications thereof are possible without departing from the spirit of the invention. Accordingly, the scope of the invention shall be determined only by the appended claims and their equivalents.

The claims refer to examples of preferred embodiments of the invention. However, the invention also refers to the use of any single feature and subcombination of features which are disclosed in the claims, the description and/or the drawings.

## Claims

1. An organic electro-luminescence device, comprising:

   an anode electrode provided between a substrate and an organic light-emitting layer and having a large amount of holes distributed on the surface being adjacent to the organic light-emitting layer such that said holes are directly injected into the organic light-emitting layer; and
   a cathode electrode provided on the organic light-emitting layer.

2. The organic electro-luminescence device according to claim 1, wherein the anode electrode has a small amount of holes distributed at an area adjacent to the substrate while having a large amount of holes distributed at an area adjacent to the organic light-emitting layer.

3. The organic electro-luminescence device according to claim 1, wherein the organic light-emitting layer includes:

   a light-emitting layer formed on the anode electrode;
   an electron carrier layer formed on the light-emitting layer; and
   an electron injection layer formed on the electron carrier layer.

4. A method of fabricating an organic electro-luminescence device, comprising the steps of:

   forming an anode electrode on a substrate;
   forming an organic light-emitting layer on the anode electrode; and
   forming a cathode electrode on the organic light-emitting layer,

   wherein said anode electrode has a large amount of holes distributed on the surface being adjacent to the organic light-emitting layer such that said holes are directly injected into the organic light-emitting layer.

5. The method according to claim 4, wherein said step of forming the anode electrode on the substrate includes:

   colliding plasma ions with a transparent electrode material target within a chamber;
   injecting a large amount of oxygen at a second half time of a deposition of said transparent electrode material by said ion collision; and
   reacting said transparent electrode material with said oxygen, thereby producing a large amount of holes.

6. The method according to claim 4, wherein the anode electrode has a small amount of holes distributed at an area adjacent to the substrate while having a large amount of holes distributed at an area adjacent to the organic light-emitting layer.

7. The method according to claim 4, wherein said step of forming the organic light-emitting layer includes:

   forming a light-emitting layer connected to the anode electrode;
   forming an electron carrier layer on the light-emitting layer; and
   forming an electron injection layer on the electron carrier layer.

# FIG.1
## RELATED ART

| | |
|---|---|
| CATHODE ELECTRODE | ~12 |
| ELECTRON INJECTION LAYER | ~10a |
| ELECTRON CARRIER LAYER | ~10b |
| LIGHT-EMITTING LAYER | ~10c |
| HOLE CARRIER LAYER | ~10d |
| HOLE INJECTION LAYER | ~10e |
| ANODE ELECTRODE | ~4 |

10a, 10b, 10c, 10d, 10e } 10

# FIG.2
## RELATED ART

# FIG.3

# FIG.4

# FIG.5

| CATHODE ELECTRODE | ~112 |
| ELECTRON INJECTION LAYER | ~110a |
| ELECTRON CARRIER LAYER | ~110b |
| LIGHT-EMITTING LAYER | ~110c |
| ANODE ELECTRODE | ~104 |

110a, 110b, 110c } 110

# FIG.6

# FIG.7A

104
102

# FIG.7B

104
102

106

# FIG.7C

# FIG.7D

# FIG.7E

European Patent Office

# EUROPEAN SEARCH REPORT

Application Number

EP 04 02 7000

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 987 774 A (UNIV PRINCETON) 22 March 2000 (2000-03-22) * paragraphs [0016], [0018], [0019] * ----- | 1-7 | H01L51/20 H01L27/00 |
| X | LEE C-T ET AL: "Effects of plasma treatment on the electrical and optical properties of indium tin oxide films fabricated by r.f. reactive sputtering" THIN SOLID FILMS, ELSEVIER-SEQUOIA S.A. LAUSANNE, CH, vol. 386, no. 1, 1 May 2001 (2001-05-01), pages 105-110, XP004230508 ISSN: 0040-6090 * page 106, column 1, line 20 - line 35 * * page 107, column 2, line 1 - line 29 * ----- | 1-4,6,7 | |
| A | BENDER M ET AL: "Dependence of oxygen flow on optical and electrical properties of DC-magnetron sputtered ITO films" THIN SOLID FILMS, ELSEVIER-SEQUOIA S.A. LAUSANNE, CH, vol. 326, no. 1-2, 4 August 1998 (1998-08-04), pages 72-77, XP004141464 ISSN: 0040-6090 * page 73, column 2, line 5 - line 15 * ----- | | TECHNICAL FIELDS SEARCHED (Int.Cl.7) H01L C23C |
| A | SZCZYRBOWSKI J ET AL: "OPTICAL PROPERTIES OF IN2O3-SNO2 FILMS IN THE TRANSPARENT AND PLASMA REFLECTION REGION" THIN SOLID FILMS, ELSEVIER-SEQUOIA S.A. LAUSANNE, CH, vol. 137, no. 2, 15 March 1986 (1986-03-15), pages 169-183, XP000021772 ISSN: 0040-6090 * abstract * ----- | | |

The present search report has been drawn up for all claims

| Place of search | Date of completion of the search | Examiner |
|---|---|---|
| Munich | 19 January 2005 | Pusch, C |

EPO FORM 1503 03.82 (P04C01)

**ANNEX TO THE EUROPEAN SEARCH REPORT
ON EUROPEAN PATENT APPLICATION NO.**

EP 04 02 7000

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-2005

| Patent document cited in search report | Publication date | Patent family member(s) | Publication date |
|---|---|---|---|
| EP 0987774 A | 22-03-2000 | EP 0987774 A2<br>JP 2000091084 A | 22-03-2000<br>31-03-2000 |

EPO FORM P0459

For more details about this annex : see Official Journal of the European Patent Office, No. 12/82